# EUROPEAN PATENT SPECIFICATION

(11) **EP 0 836 142 B1**
(45) Date of publication and mention of the grant of the patent: **11.12.2002**
(21) Application number: 97307503.9
(22) Date of filing: 25.09.1997
(51) Int. Cl.: G06F 11/20

(54) **Semiconductor memory capable of mapping bad blocks**
Halbleiterspeicher zur Abbildung Fehlerhafter Speicherbausteinen
Mémoires à semi-conducteurs capable de transformation topographique de blocs défectueux

(30) Priority: 08.10.1996 KR 9644616
(43) Date of publication of application: 15.04.1998
(73) Proprietor: Samsung Electronics Co., Ltd., Suwon-city, Kyunggi Province (KR)
(72) Inventor: Sung-Soo, Lee, Songpa-ku, Seoul (KR); Young-Ho, Lim, Yongin-shi, Kyunggi-do (KR)
(74) Representative: Style, Kelda Camilla Karen

(56) References cited:
- EP-A- 0 528 280
- EP-A- 0 590 809
- EP-A- 0 679 996
- US-A- 4 398 248

## Description

The invention relates to a semiconductor memory having redundancy circuits which repair defects in the memory, more particularly to a semiconductor memory capable of mapping bad blocks which are identified to as containing defects.

Generally in the manufacturing reliability for semiconductor memory chips, it is important to increase the yield rate. It may not be permitted for a memory chip containing defective memory cells, even when it has just one defective cell, to be a normal product. But there could be an exception, for example an apparatus, such as an automatic reply device employed in telephones, permits some memories (i.e., DRAM, SRAM and EEPROM) which contain defective memory cells to be used therein, for the sake of lowering manufacturing cost as much as possible. It is well known that higher integration density increases the possibility that defective memory cells are present. As manufacturing techniques are becoming more difficult and complicated to give a higher packing density of semiconductor memories, obstacles that may reduce the yield are caused by particles (or debris) which are introduced while the manufacturing steps are being carried out. There have been various attempts to improve the yield rate.

In order to get a good yield rate, it is advantageous to improve the manufacturing technology by which the generation of defective memory cells could be reduced. But such efforts are no more effective beyond speculated limitations in the processing environment. As another solution for improving the yield rate, an advanced semiconductor memory device has an internal construction able to deal with defective regions formed therein during the manufacturing process, i.e., redundancy technology. A memory device employing such a redundancy technique includes a spare memory cell array (or a redundant memory cell array), in addition to a normal memory cell array, which contains a plurality of spare memory cells to be substituted for defective memory cells embedded in the normal memory cell array so as to make the device a non-defective article when considered as a whole. It is impossible to perform the redundancy function when the number of defective cells is larger than the number of spare memory cells. Such a device could not be used.

Redundancy circuitry, basically, includes a redundant cell array which consists of a matrix of redundant cells, arranged in row and column sections and control circuits which store address information about the defective cells (such address information is referred to as defective addresses, hereinafter) and compares present addresses to the defective addresses so as to determine whether the present addresses is involved with the defective cells. Substitution units with the redundant cell array are arranged into rows, columns or block sections. For example, a row redundancy circuit makes a redundant row (corresponding to a defective row) be activated to exchange with the defective row, when the present row address applied from an external path is the same as the address that has been already settled in a programming circuit, such as a row redundant decoder. A column redundancy circuit utilizes a column redundant decoder in which address information for normal columns containing one or more defective cells is identified, so that spare columns corresponding to the defective column addresses are substituted for defective columns of a normal memory cell array. One known row redundancy technology is disclosed in a preceding patent article such as Korean Patent Application No. 95-1737.

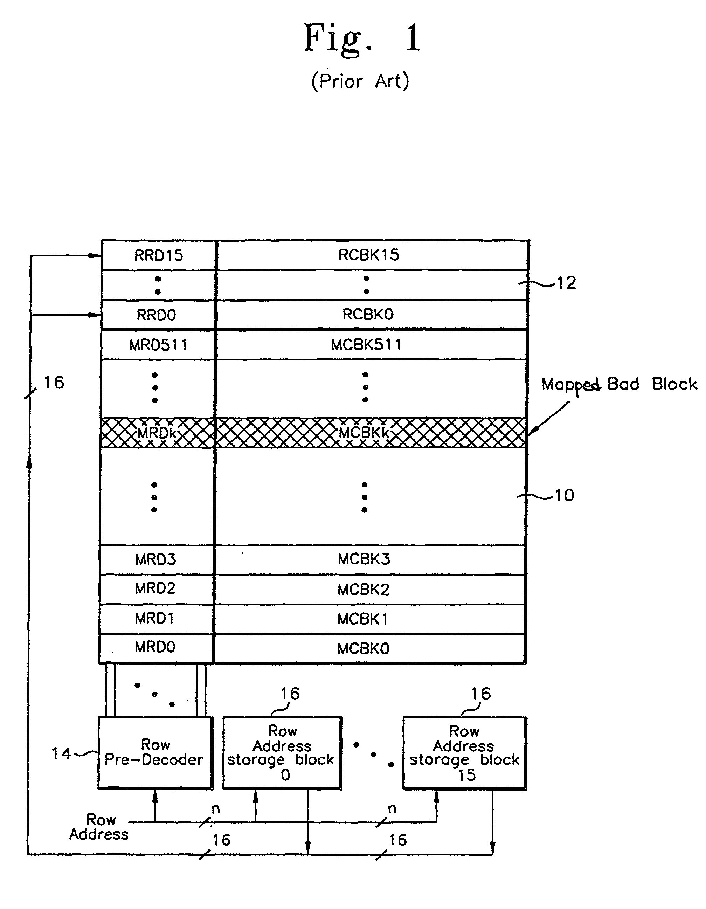

Fig. 1 shows a schematic structure of a general memory device having the redundancy circuitry. The following are shown main memory cell array 10, row redundant cell array 12, row pre-decoder 14, row address storage block 16, normal row decoders MRD0 to MRD511 and redundant row decoders RRD0 to RRD15. Main memory cell array 10 consists of 512 row blocks MCBK0 to MCBK511 to which 512 row decoders are correspondingly coupled. Redundant row blocks RCBK0 to RCBK 15 are associated with redundant row decoders RRD0 to RRD15. Those are set to select redundant blocks corresponding to defective row blocks of the main memory cell array 10. It is not shown in Fig. 1 that the main memory cell array 10 is also provided with a column redundant cell array, sense amplifiers, column decoders, data input/output buffers, data input/output selection circuits and read/write control circuits.

Row pre-decoder 14 generates pre-decoding signals for selecting row blocks of main memory cell array 10 in response to row address signals. Row address storage blocks 16 receive row addresses relevant to defective row blocks and then generate control signals which cause a normal row decoder MRDk (k is one of 0 to 511) and a redundant row decoder RRDk be disabled and enabled, respectively, when the received address is equal to one of the preliminarily programmed addresses as to be repaired.

The normal row decoders activate block selection lines (not shown) embedded in the main memory cell array 10 in response to pre-decoding signals supplied from row pre-decoder circuit 14, each block selection line being alternatively conductive so as to activate one of row blocks. At the same time, the redundant row decoders activate block selection lines embedded in the redundant memory cell array 12 in response to redundant block selection signals provided from the row address storage blocks, so that an alternatively enabled block selection pre-decoding signal makes its corresponding row block of the redundant memory cell array be activated thereby. Therefore, by the aforementioned operation, a normal row block of the main memory cell array 10, having one or more defective memory cells, may be substituted with a redundant row block of the redundant memory cell array 12 which has the same address as the defective row block of the main memory cell array 10. The row address storage block 16 employs a programmed circuit with nonvolatile elements, such as fuses or any kinds of ROM transistors (PROM, EPROM and EEPROM). The elements mostly used for the defective address storage means like the blocks 16 of Fig. 1 are polysilicon fuses which can be blown out by means of laser beam or current flow.

The fuse programming by current flow needs additional pads and pins for receiving a current large enough to blow a fuse out, increasing a chip size, though it can be performed before and after packaging. Laser blowing programming is applicable only before the packaging. The other way to program defective addresses is to use nonvolatile memory units.

Meanwhile, as the number of defective memory spaces increases, the required number of redundant rows or columns correspondingly does, thereby increasing the size of the memory chip. Therefore, as shown in Fig. 1 where 16 redundant row blocks are allocated for 512 main row blocks, it is a general concept, in preparing redundant memory cell spaces for the capacity of the main memory cell array, to minimize the space for redundant rows or columns such that the range of redundant space is not less than the usually required capacity for redundancy. A necessary size of the redundant cell array may be evaluated in accordance with a given memory capacity of the main memory cell array.

If, unfortunately, the number of defective blocks becomes larger than that of redundant blocks, it is impossible to substitute entire defective blocks with the prepared redundant blocks. Therefore a user who wants to operate his personal computer employing the EEPROM as shown in Fig. 1, as a hard disk, must identify one or more unrecoverable defective blocks (as we know, in a usual personal computer, those blocks are referred to as bad blocks) generated from the shortage of redundant blocks. In Fig. 1, the identification (hereinafter referred to as "mapping" for bad blocks) is carried out for the abandoned row block MRDk of the main memory cell array 10, the MRDk being out of the substitution capacity of the array. Once designated as a bad block, the row block MRDk may not be accessed with its corresponding address by means of an internal processing algorithm of a controller. When more than one bad memory blocks, also being out of redundant capacity and thus abandoned, are revealed on the main memory cell array, the user would not have a smart mapping pattern throughout an entire memory block space because such defective blocks may be positioned at random thereon.

Since almost all of the nonvolatile memories such as EEPROMs (or flash memories) have at least a few defective memory cells, the mapping process by the user is usually carried out for every chip thereof before actual use. Namely, the user may not use a nonvolatile memory, for example as a hard disk, until he has finished mapping the bad blocks, causing inconvenience to him.

EP-A-679996 discloses a semiconductor device with a main memory cell, a redundant memory cell and a redundant address data cell. The redundant address cell memorized the address of a redundant memory cell which replaces a failed memory cell in the main memory cell.

EP-A-528280 discloses a memory card apparatus which uses EEPROMs. The EEPROM has a data area and a remedy area. If a write error occurs in the data area and the remedy area is full, a free block in the data area can be used.

Accordingly, an aim of certain embodiments of the invention is to provide a semiconductor memory without bad block mapping by a user.

Another aim is to provide a semiconductor memory capable of repairing defective memory cells without storing addresses relevant to the defective memory cells.

A further aim is to provide a semiconductor memory capable of repairing defective memory cells with enhanced operating speed.

According to one aspect of the invention, there is provided a semiconductor memory in accordance with appended independent Claim 1.

The semiconductor memory may perform an automatic bad block mapping without effort by a user so that pseudo-usable blocks are arranged on the main memory cell array in a sequential order as if those blocks substantially containing one or more defective blocks are non-defective blocks.

Other features and advantages of the invention will become apparent in the following detailed description of the preferred embodiment, with reference to the accompanying drawings, of which:
Fig. 1 illustrates an architecture of a conventional semiconductor memory, in which a bad block is designated by a mapped position throughout memory blocks;
Fig. 2 is a block diagram illustrating an architecture of a semiconductor memory embodying the present invention, showing a mapped position for a bad block as an example;
Fig. 3 is a circuit diagram in combination with the memory cell array, the row decoders and flag cell arrays of Fig. 2;
Fig. 4 is a circuit diagram of the flag sense amplifier shown in Fig. 2;
Fig. 5 is a circuit diagram of the flag decoder shown in Fig. 2;
Fig.6 is a circuit diagram of the block selection controller shown in Fig. 2;
Fig. 7 is a circuit diagram of the row pre-decoder shown in Fig. 2; and
Fig. 8 is a timing diagram illustrating the operation of the memory embodying the present invention.

Hereinbelow, practical embodiments of the invention will be as follows, with the appended drawings. Referring now to the drawings, like reference characters designate like or corresponding parts throughout the several views. The preferred embodiment described hereinbelow may be applicable to a flash EEPROM having a NAND-type cell arrangement, as an example.

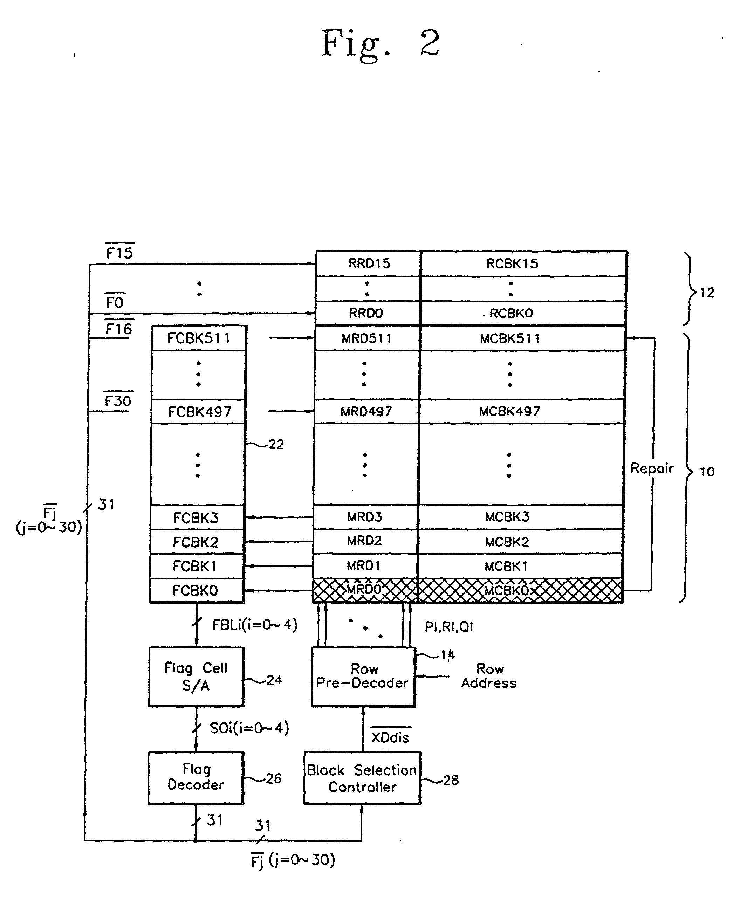

Referring to Fig. 2, main memory cell array 10 consists of 512 normal row blocks MCBK0 to MCBK511 and redundant memory cell array 12 consists of 16 redundant row blocks RCBK0 to RCBK15. Each of the normal and redundant row blocks is correspondingly coupled to each of normal and redundant row decoders RRD0 to RRD15 and MRD0 to MRD15. It should be noted that there is mapping circuitry which includes row pre-decoder 14, the normal row decoders MRD0 to MRD511, the redundant row decoders RRD0 to RRD511, flag cell array 22 consisting of flag cell blocks FCBK0 to FCBK511, flag sense amplifier 24, flag decoder 26 and block selection controller 28, not only for substituting defective row blocks of the main memory cell array with non-defective row blocks but also for making up a mapped arrangement of bad blocks of itself.

Row pre-decoder 14 generates pre-decoding signals P1, Q1 and R1 (1 is 0 to 7) to select normal row blocks of the main memory cell array in response to row address signals. Flag cell blocks FCBK0 to FCBK511 of the flag cell array are arranged with the same number as the normal row blocks MCBK0 to MCBK511 and store information about their corresponding normal row blocks, each information providing a unique identification for each block in order to prepare a guidance of the mapping configuration according to an embodiment of the invention. Flag sense amplifier 24 is connected to flag cell array 22 through flag bit lines FBLi (i is 0 to 4) and reads out the information relevant to the normal row blocks therefrom, generating defective block status signals SOi (i is 0 to 4). Flag decoder 26 receives the defective block status signals SOi from flag sense amplifier 24 and then generates repair block selection signals FjB (j is 0 to 30; hereinafter the suffix "B" is used to mean a complementary signal of its corresponding numeral, so F15B is the complementary signal of F15). Block selection controller 28 receives the repair block selection signals FjB from the flag decoder 26 so as to cause normal row decoders associated with defective row blocks to be inactivated.

When the number of defective row blocks of the main memory cell array 10 is greater than the number of redundant row blocks RCBK0 to RCBK15 (hereinafter, such row blocks are referred to as extra defective row blocks), the extra defective row blocks are substituted with non-defective row blocks arranged on main memory cell array in the order from MCBK511 (i.e., the most significant row block) to MCBK0 (i.e., the least significant row block). Assuming that the number of the defective row blocks is 18, two extra defective blocks may be substituted with MCBK511 and MCBK510 of the main memory cell array 10 while 16 defective row blocks have been preliminary interchanged with all of the redundant row blocks RCBK0 to RCBK15, informing a user that row blocks MCBK509 to MCBK0 are permitted to be used as non-defective row blocks. It should be understood that the row blocks MCBK509 to MCBK0 regarded as non-defective blocks (or usable blocks) by a user may contain one or more defective blocks. As a result, the user need not carry out a bad block mapping sequence by himself, and can appreciate which row blocks are in the usable condition according to the information provided by the number of extra defective row blocks.

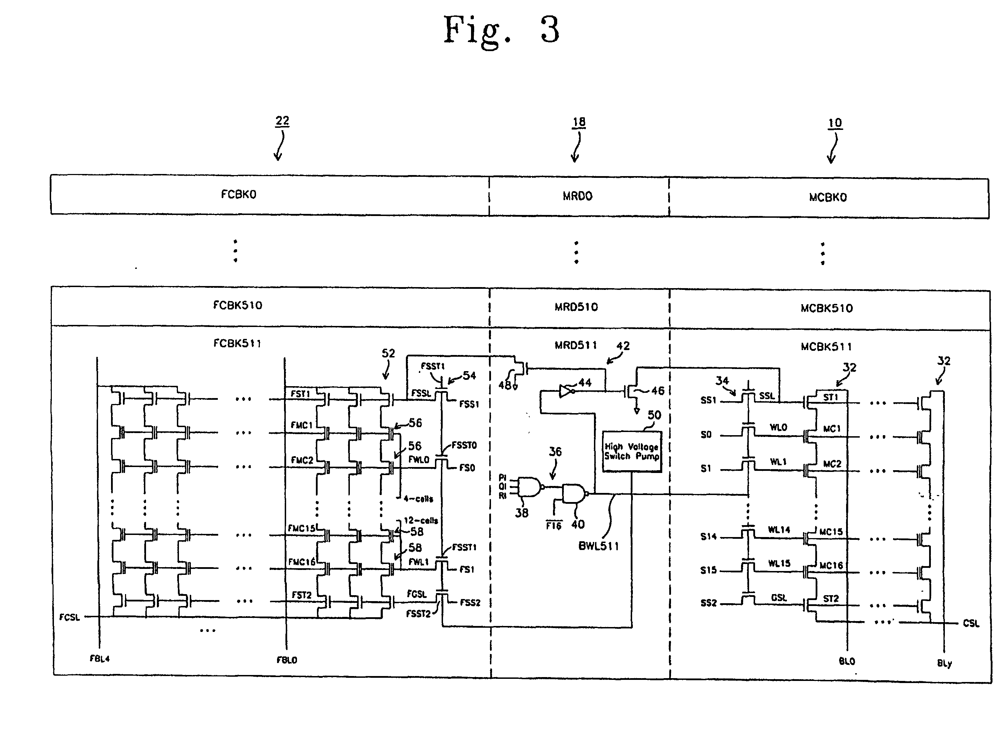

Fig. 3 shows the circuit in connection with the main memory cell array 10, normal row decoders MRD0 to MRD511 and flag cell array 22, representatively disclosing an operative connection between normal row block MCBK511 of main memory cell array 10, normal row decoder MRD511 and flag cell block FCBK511 of flag cell array 22 as a coupling unit for an address. The arrangement for the normal row block, normal row decoder and flag cell block for MCBKi, MRDi and FCBKi are the same as illustrated in Fig. 3. Referring to Fig. 3, word lines WL0 to WL15 coupled to word line source signals S0 to S15 are connected to gates of cell transistors MC1 to MC16 which are connected from string selection transistor ST1 to ST2 in cell string 32 of a NAND-type logic. Cell strings such as the numeral 32 are repeatedly arranged in block MCBK511. Each string selection transistor of a cell string is coupled to its corresponding bit line ― ST1 is coupled to bit line BL0 and the sources of all transistors ST2 are bound to common source line CSL. The word lines WL0 to WL16 are coupled to word line source signals S0 to S15 through gate transistors of word line gate circuit 34. Two gate transistors of the gate circuit 34 connect string selection line SSL and GSL, respectively coupled to the gates of ST1 and ST2, to string selection signals SS1 and SS2, respectively. All gate electrodes of the transistors of gate circuit 34 are coupled to block word line BWL511, supplied from decoder MRD511, which is activated when the present block MCBK511 is selected.

Normal row decoder MRD511 receives block selection signals P1, Q1 and R1 (1=0 to 7) from row pre-decoder 14 of Fig. 2, at the input terminals of NAND gate 38. The output of the NAND gate 38 and redundant block signal F15B generated by the flag decoder 26 of Fig. 2 are applied to the input terminals of NAND gate 40. The output node of the NAND gate 40 is coupled to block word line BWL511 and an output of high voltage switch pump 50. The output from NAND gate 40 is led to the gate of NMOS transistor 46 which is connected between a node on SSL and ground, through inverter 44. The gate of transistor 46 is coupled to gate of NMOS transistor 48 which is connected between a node on flag string selection line FSSL and ground. The transistors 46 and 48 make string selection line SSL and flag string selection line FSSL be pulled down to a ground level when blocks MCBK511 and FCBK511 are not selected.

Flag cell array 22 has flag cell strings 52 of the same structures with cell strings 32 of the normal row blocks such as MSBK511, each flag cell string consists of flag selection transistors FST1 and FST2 and flag cell transistors FMC1 to FMC16.

But, it should be noted that the arrangement and interconnection configurations of flag word lines FWL0 and FWL1 and flag bit lines FBL0 to FBL4 are quite different from those in the normal row block MCBK511. Flag word line FWL0, the first word line of the flag cell block, is formed by wiring four word lines each coupled to control gates of the flag cell transistors that are arranged along row direction. Another flag word line FWL1, as the second word line of the block FCBK0, is formed by wiring twelve word lines each coupled to control gates of the flag cell transistors which are also arranged along the row direction. Namely, the control gates of the first through fourth flag cell transistors FMC1 to FMC4 in flag cell strings 52 are all connected to the flag word line FWL0 which is coupled to flag word line source signal FS0 through flag gate transistor FSGT0, and the control gates of the fifth through sixteenth transistors FMC5 to FMC16 are all connected to the flag word line FWL1 which is coupled to flag word line source signal FS 1 through flag gate transistor FSGT1. Flag word line FWL0 acts as a selected word line while FWL1 acts as a non-selected word line in flag cell block FCBK511. Such an interconnection scheme with the flag word lines makes it possible to secure sensing stability for off-cells which is formed by programming because, even if three cell transistors among four selected cell transistors in one flag cell string have defects as a worst case, the remaining one flag cell transistor can provide information for the off-cell.

Flag string selection line FSSL is coupled to the gates of flag string selection transistors FST1 and receives flag string selection signal FSS1 through flag gate transistor FSSTI. Gates of another flag string selection transistors FST2 are coupled to flag string selection line FGSL which receives flag string selection signal FSS2 through flag gate transistor FSST2, all sources of the FST2 transistors being connected to a flag common source line FCSL. All of the gates of the flag gate transistors FSST1, FSGT0, FSGT1 and FSST2 are coupled to block word line BWL511 from normal row decoder MRD511.

Meanwhile, each of flag bit lines FBL0 to FBL4 is coupled to three flag cell strings in parallel, Those parallel connections between flag bit lines and flag cell strings may be advantageous for enhancing sensing speed of an on-cell, while detecting defective blocks, because current from on-cells flows through plural paths (e.g., three current paths) to ground; Furthermore, even when two flag cell strings among the three strings corresponding to one bit line contain defects as a worst case, it may be possible to succeed with a sensing operation by using the remaining one string.

The programming and erase operations in the flag cell array 22 will be described from now on, with reference to TABLE 1 as follows, TABLE 1 demonstrates the case of programming and erasing a selected flag cell block such as FCBK511.

**TABLE 1**

| **Signal** | **Programming** | **Erasing** |
|---|---|---|
| BWL | Vpgm+ΔV | Vcc |
| FSSL | Vcc | FLOATING |
| FS0 | Vpgm(18V) | 0V |
| FS1 | Vpgm(18V) | 0V |
| FGSL | 0V | FLOATING |
| FCSL | 0V | FLOATING |
| FBL (selected) | 0V | FLOATING |
| FBL (unselected) | 0V | FLOATING |

Prior to programming, the selected flag cell block is put into an erase condition in which, as shown on TABLE 1, block word line BWLm (m is one of 0 to 511) is pulled up to Vcc (power supply voltage), and flag word line source signals FS0 and FS 1 retain 0V while flag string selection lines FSSL and FGSL, and flag common source line FCSL and all flag bit lines are floating (it means there is no bias condition applied thereto). Thus, all of the flag cell transistors have negative threshold voltages for the on-cells.

In order to set the program condition for the flag cell block, as shown on TABLE 1, the voltage level of flag word line source signals FS0 and FS1 goes to Vpgm which is about 18V that is applied to flag word lines FWL0 and FWL1 through gate transistors FSGT0 and FSGT1 whose gates are coupled to block word line BWLm of Vpgm+ ΔV (the voltage level which can have the program voltage Vpgm passed through the gate transistor without a voltage drop by a threshold voltage). During this operation, flag string selection line FSSL is held at Vcc, and FGSL and FCSL are pulled down to 0V. Meantime, to the flag bit line selected is applied 0V while to the unselected bit lines Vcc. On the other side, the corresponding normal block such as MCBK511 vs. FCBK51 I is not activated during the program operation with the flag cell block, because the string selection signals SS1 and SS2, and word line source signals S0 to S15 are held at 0V, even though the block word line BWLm i.e., BWL511 becomes the Vpgm+ΔV. More detailed description related to a redundant programming with the flag cell blocks will be provided hereinafter.

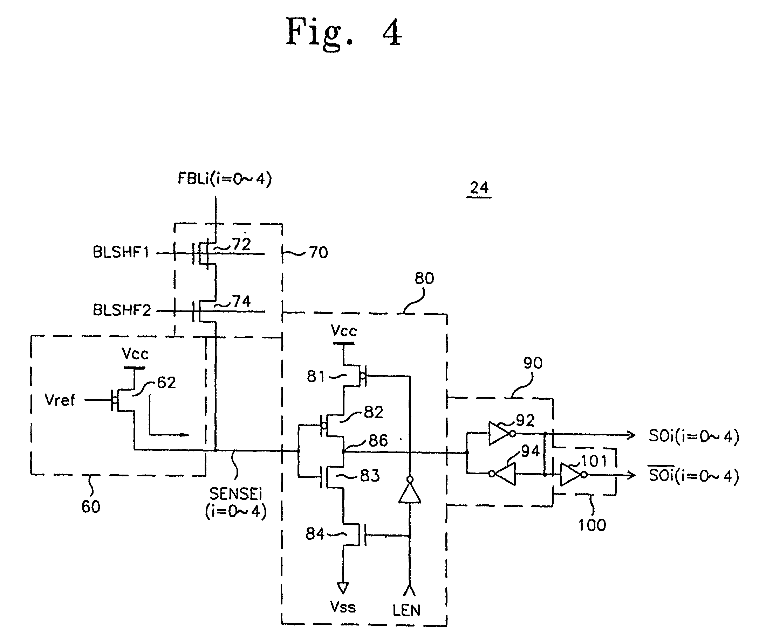

Figs. 4 through 7 illustrate applicable circuit configurations of the block components flag sense amplifier 24, flag decoder 26, block selection controller 28 and row pre-decoder 14, in this order.

Referring to Fig. 4, the sense amplifier 24 is formed of current supply 60, isolation circuit 70, tri-state inverter 80, latch 90 and inverter 101. Current supply 60 consists of PMOS transistor 62, the gate of which is coupled to reference voltage Vref and the drain to Vcc. Isolation circuit 70, depletion transistor 72 and NMOS transistor 74 are connected between flag bit line FBLi (i is one of 0 to 4; namely, five sense amplifiers such as Fig. 4 are substantially provided for the structure of Fig. 1) and sensing node SENSEi (i is one of 0 to 4) coupled to the source of transistor 62, those gates being coupled to flag bit line shielding signals BLSHF 1 and BLSHF2, respectively. Tri-state inverter 80 is constructed of, as is well known, a pair of PMOS and NMOS transistors 82 and 83 the gates of which are coupled to sensing node SENSEi, and a pair of PMOS and NMOS transistors 81 and 84 whose gates respond to enable signal LEN. The input of latch 90 is coupled to the output node 86 of tri-state inverter 80. From the output of latch 90, defective block status signals SOi and SOiB (i is one of 0 to 4) are generated so as to be applied to flag decoder 26. The bit number of the defective block status signals generated from five sense amplifiers such as aforementioned in Fig. 4 is correspondingly equal to that of the flag bit lines FBL0 to FBL4 in Fig. 3.

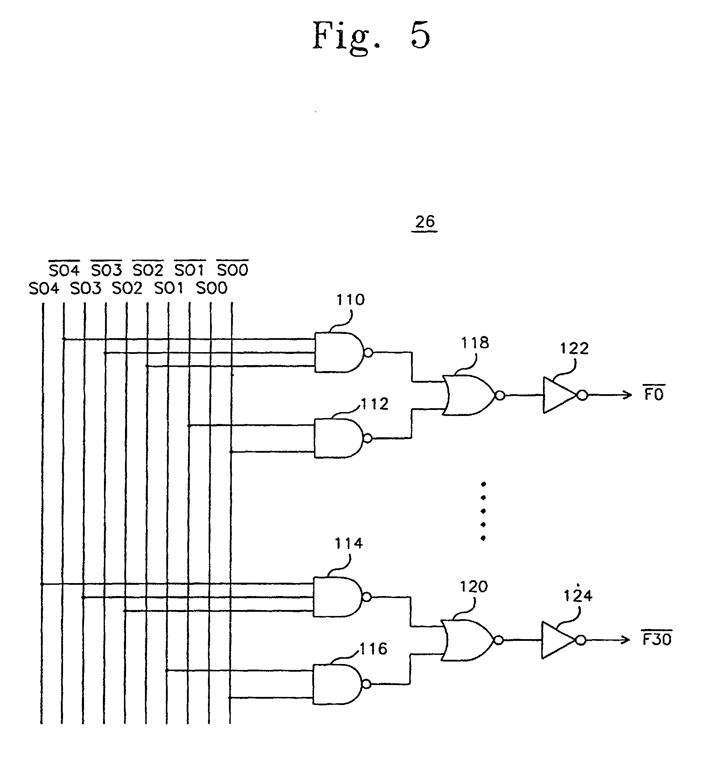

Referring to Fig. 5, in order to create each repair block selection signal, defective block status signals SO0 to S04 and their complementary signals SO0B to S04B are applied to input terminals of NAND gates 110 to 116. The entrance arrangements of the defective block status signals for the NAND gates are set in a rule of binary combinations from SO4B-SO3B-SO2B-SO1B-SO0B to SO4-SO3-SO2-SO1-SOB vs. F0B to F30B. The outputs of the NAND gates are generated as repair block selection signals F0B to F30B, through NOR gates 118 to 120 and inverters 122 to 124. It could be seen that the number of the repair block selection signals becomes 31 of F0B to F30B in current state because one of code combinations, i.e., "11111", with the five bits of the defective block status signals identifies normal (non-defective) condition of its corresponding blocks.

The number 31 represents the number of programming patterns available in the flag cell block. The created specifications of the repair block selection signals F0B to F30B, according to coded combinations with the defective block status signals SO0 to SO4, are demonstrated in TABLE 2 where selected repair blocks (blocks which participate in substitution orders for redundancy, either redundant row blocks or normal row blocks) corresponding to the repair block selection signals are accompanied therewith. As an example, in TABLE 2, when the associated codes with the defective block status signals S04 to SO0 are set into "01111", repair block selection signal F15B becomes enabled and then causes redundant row block RCBK15 to be selected. Otherwise, the code "10000" of S04 to SO0 is provided for F16B which activates normal row block MCBK511 as a repair block. It will be well understood by TABLE 2 that the substitution. sequence is proceeded in the order from the first redundant row block RCBK0 towards the least significant normal row block MCBK0, such as RCBK0, RCBK1,.., MCBK511 (the most significant normal row block), MCBK510,.., in this order.

**TABLE 2**

| **FjB** | **SO4** | **SO3** | **SO2** | **SO1** | **SO0** | **repair block to be substituted** |
|---|---|---|---|---|---|---|
| F0B | 0 | 0 | 0 | 0 | 0 | RCBK0 |
| F1B | 0 | 0 | 0 | 0 | 1 | RCBK1 |
| F2B | 0 | 0 | 0 | 1 | 0 | RCBK2 |
| · | · | · | · | · | · | · |
| · | · | · | · | · | · | · |
| F15B | 0 | 1 | 1 | 1 | 1 | RCBK15 |
| F16B | 1 | 0 | 0 | 0 | 0 | MCBK511 |
| F17B | 1 | 0 | 0 | 0 | 1 | MCBK510 |
| · | · | · | · | · | · | · |
| · | · | · | · | · | · | · |
| F28B | 1 | 1 | 1 | 0 | 0 | MCBK499 |
| F29B | 1 | 1 | 1 | 0 | 1 | MCBK498 |
| F30B | 1 | 1 | 1 | 1 | 0 | MCBK497 |
| | 1 | 1 | 1 | 1 | 1 | non-defective block |

As aforementioned, since the number of the defective block status signals is correspondingly equal to that of the flag bit lines, such as SO0 to S04 vs. FBL0 to FBL4, TABLE 3 as follows, demonstrates the relationship between sets of programmed data bits for the flag bit lines and substituted blocks for redundancy along with the increase of the number of defective blocks, also shows that coded configurations for the flag bit lines are the same as those of the defective block status signals.

**TABLE 3**

| **the number of** **defective blocks** | **SO4** | **SO3** | **SO2** | **SO1** | **SO0** | **repair block** **to be substituted** |
|---|---|---|---|---|---|---|
| 1 | 0 | 0 | 0 | 0 | 0 | RCBK0 |
| 2 | 0 | 0 | 0 | 0 | 1 | RCBK1 |
| 3 | 0 | 0 | 0 | 1 | 0 | RCBK2 |
| · | · | · | · | · | · | · |
| · | · | · | · | · | · | · |
| 16 | 0 | 1 | 1 | 1 | 1 | RCBK15 |
| 17 | 1 | 0 | 0 | 0 | 0 | MCBK511 |
| 18 | 1 | 0 | 0 | 0 | 1 | MCBK510 |
| · | · | · | · | · | · | · |
| · | · | · | · | · | · | · |
| 29 | 1 | 1 | 1 | 0 | 0 | MCBK499 |
| 30 | 1 | 1 | 1 | 0 | 1 | MCBK498 |
| 31 | 1 | 1 | 1 | 1 | 0 | MCBK497 |
| | 1 | 1 | 1 | 1 | 1 | non-defective block |

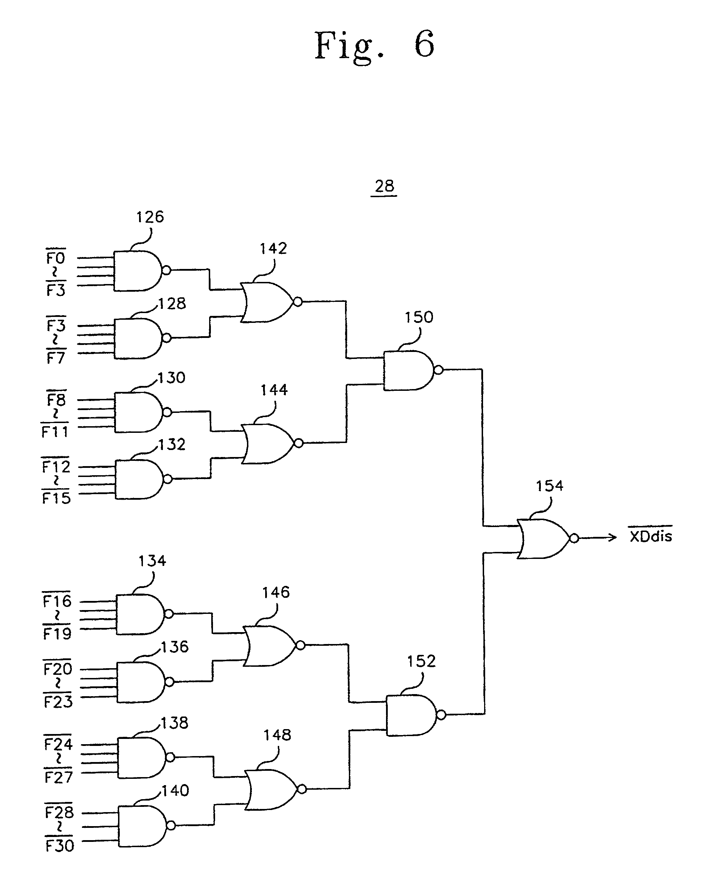

Block selection controller 28, referring to Fig. 6, generates normal row decoder disable signal XDdisB through NOR gate 154 which receives outputs of NAND gates 150 and 152. Input terminals of NAND gate 150 are coupled to outputs of NOR gates 142 and 144, and input terminals of NAND gate 152 to outputs of NOR gates 146 and 148. Inputs of the NOR gates 142 to 148 are coupled to outputs of NAND gates 126 to 140, each NOR gate receiving output signals from two NAND gates. To each of NAND gates 126 to 140 repair block selection signals are applied by four in order, such that F0B to F3B are applied to NAND gate 126 and so on. Row decoder disable signal XDdisB is applied to row pre-decoder 14.

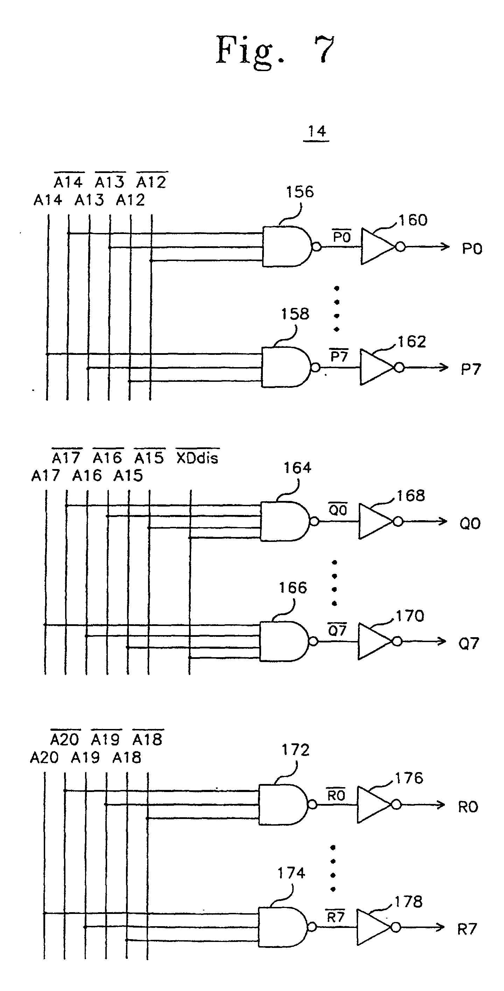

Now, referring to Fig. 7, row pre-decoder 14 has three decoder groups corresponding to three sets of pre-decoding signals P0B to P7B, Q0B to Q7B and R0B to R7B. For generating P0B to P7B, NAND gates 156 to 158 receive row address signals A12 to A14 (including their complementary signals A12B to A14B) and inverters 160 to 162 convert output signals of the NAND gates to the first set of pre-decoding signals P0B to P7B. For Q0B to Q7B, NAND gates 164 to 166 receive A15 to A17 (including their complementary signals A15B to A17B) and further receive row decoder disable signal XDdisB generated from block selection controller 28, which means that the second set of pre-decoding signals Q0B to Q7B are cut off when XDdisB becomes a conduction state of low level. Namely, all of the normal row blocks which are conditioned under coded control with Q0B to Q7B would not be activated thereby. The Q0B to Q7B are led to outputs of NAND gates 164 to 166 through inverters 168 to 170. The third set of pre-decoding signals R0B to R7B is generated through NAND gates 172 to 174 and inverters 176 to 178, each of NAND gates 172 to 174 receiving row address signals A18 to A20 (including their complementary signals A18B to A20B). The pre-decoding signals are applied to the normal row decoders as shown in Fig. 2 or Fig. 3.

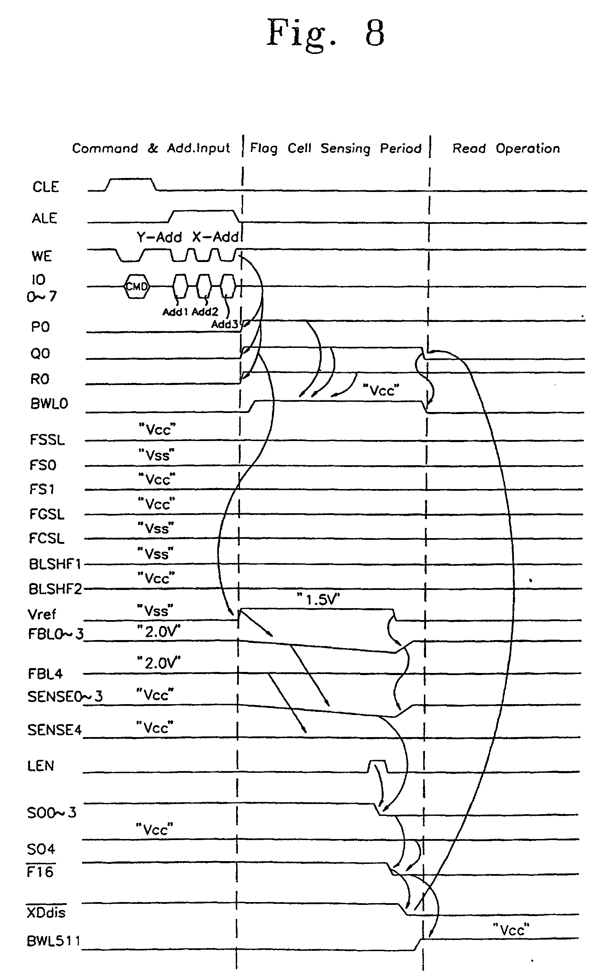

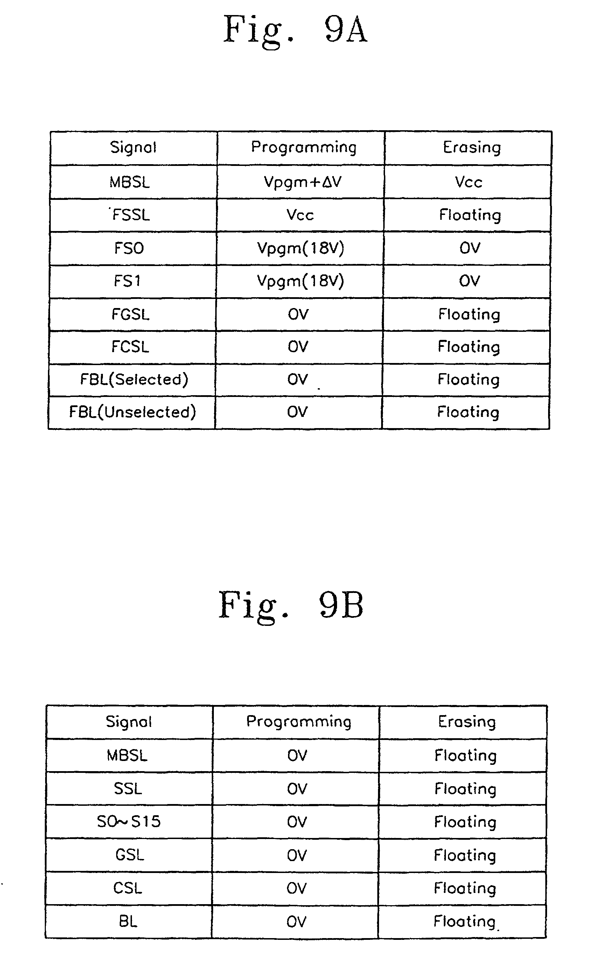

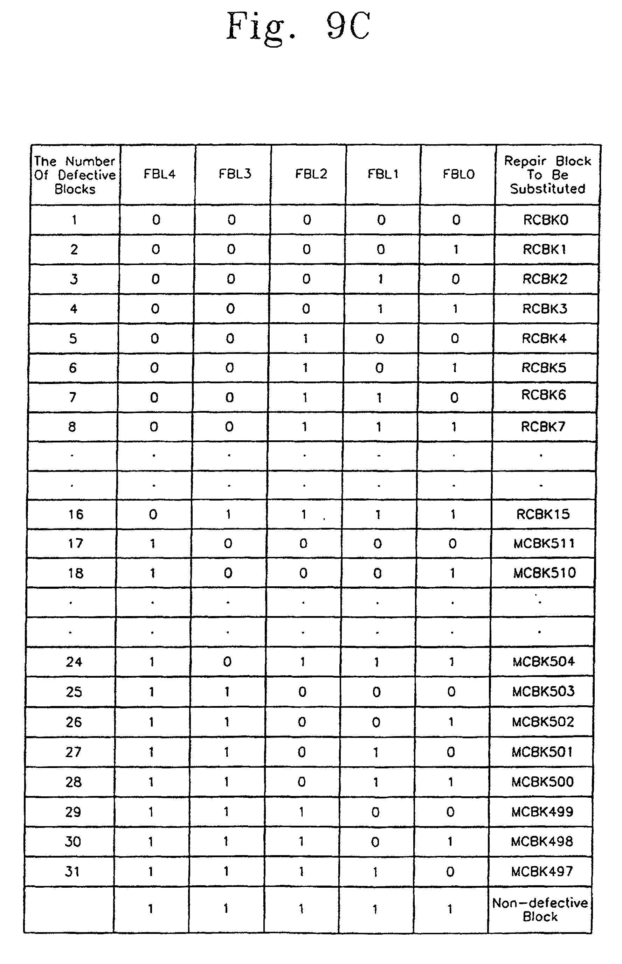

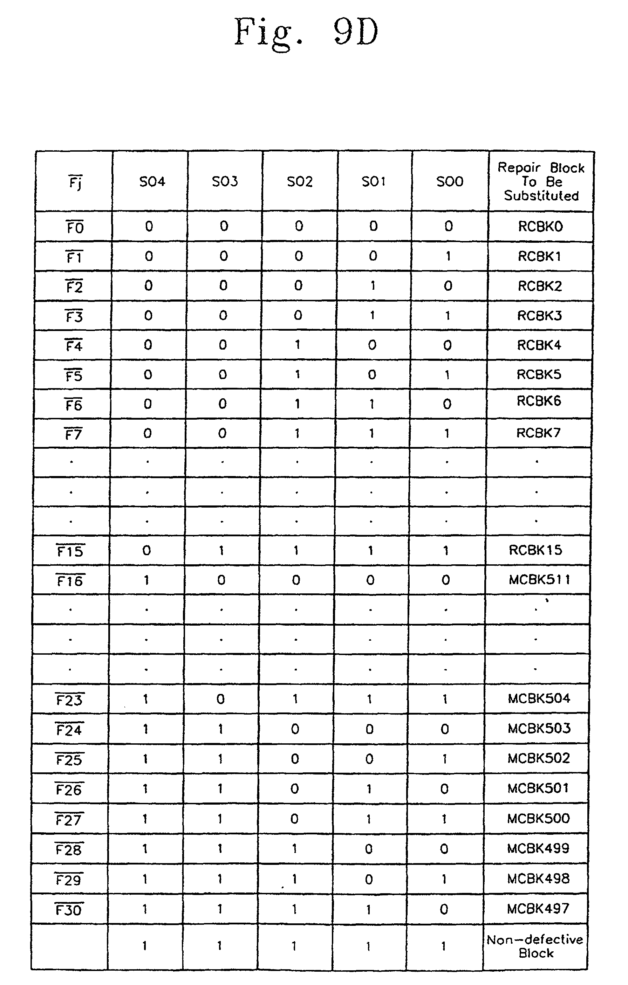

From now on, the substitution and mapping mechanism will be discussed referring to Fig. 8, which shows the timing flow during a read operation of the memory embodying the invention. As shown in Fig. 8, the sequential operation includes a command/address input period, a flag sensing period and a reading period, in this order. In the command/address input period, a command signal CMD is admitted to be entered therein through an input/output pin IO0 to IO7 in response to activations of command latch enable signal CLE and write enable signal WE, determining an operating mode. This timing is assumed of having a command signal for a read operation. After receiving command signal CMD by the first low transition of WE, address signals A0 to A20 are partially supplied, by eight bits, through the input/output pins IO0 to IO7 in response to subsequent low transitions of WE.

Assuming that normal row block MCBK0 is regarded as the seventeenth defective block (all of the denoted numerals in Fig. 8 are corresponding to the selection of MCBK0), when the address for MCBK0 appears, a sensing operation will be performed for its corresponding flag cell block FCBK0 in the flag sensing period. During the command/address input period, since, in flag sense amplifier 24, reference voltage Vref is Vss and flag bit line shielding signals BLSHF1 and BLSHF2 are Vss and Vcc, respectively, sensing nodes SENSEi are pulled up to Vcc as a precharge level and flag bit lines FBL0 to FBL4 are held at a precharge voltage level about 2V that is to be reduced by threshold voltage of depletion transistor 72.

After finishing the address receipt, flag cell sensing operation begins therefrom. It should be noted that the seventeenth defective block MCBK0, being out of the redundant capacity made up with the sixteen redundant row blocks, corresponds to flag cell block FCBK0 as shown in Fig. 2 or Fig. 3 in which flag bit lines FBL0 to FBL4 has been already set into the programming codes of "10000" in order to be substituted with its corresponding repair block MCBK511 as shown in TABLE 3. First, Vref is pulled up to 1.5V from Vss so as to cut off the current supply. In flag cell block FCBK0, since BWL, FSSL, FS0, FS1, FGSL and FSSL are Vcc, Vss, Vcc, Vcc and Vss, respectively, and FBL0 to FBL3 but not FBL4 are all "0", flag cell transistors connected to FBL4 become off-cells while flag cell transistors connected to FBL0 to FBL3 are on-cells. Because there are current flows through on-cells, sensing nodes SENSE0 to SENSE3 corresponding to the FBL0 to FBL3 are pulled down to Vss while sensing node SENSE4 for FBL4 retains the present voltage level of Vcc. Meantime, provided that a capacitance value on each flag bit line is 3pF and a current value flowing through the on-cells is 5uA, the lapse time t for making a decrease from the voltage level of 2V of the flag bit line to about 1.8V may be obtained as follows:$\text{t} \text{=} \frac{\text{c} \text{·Δ} \text{V}}{\text{I}} \text{=} \frac{\text{3} \text{x} {\text{10}}^{\text{-12}} \text{x} \text{0.2}}{\text{3} \text{x} \text{5} \text{x} {\text{10}}^{\text{-6}}} \text{= 40(} \text{ns} \text{)}$

The result of the above equation means that it is possible for the sense amplifier to detect the existence of on-cells in 40ns so that a voltage decrease by at least 0.2V on the flag bit line coupled to on-cells can make a voltage fluctuation enough for the detection at the sensing node at which the capacitance is much lower than that of the flag bit line. Further shortening of the sensing time for on-cells may be accelerated by multiplying the number of flag cell strings coupled to one flag bit line in parallel. Such an enhancement of the sensing speed would be involved in reducing redundancy time with substitutions.

Returning to Fig. 8, after developing the sensing nodes SENSE0 to SENSE3 corresponding to flag bit lines FBL0 to FBL3 coupled to the on-flag cells, enable signal LEN goes to high level and thereby defective block status signals SO0 to SO3 are pulled down to low through tri-state inverter 80 and latch 90 while SO4 is high. The combination code "10000" with SO4 to SO0 are applied to flag decoder 26 and makes the seventeenth repair block selection signal F16B be activated while other repair block selection signals are all high. The selected repair block selection signal F16B, in Fig. 6, causes row decoder disable signal XDdisB to be activated. The conductive XDdisB, as shown in Fig. 7, makes it possible to generate row pre-decoding signals Q1 of low levels which lets the MCBK0 be inactivated. Noticeably referring to Fig. 3, in row decoder MRD511 which is engaged in FCBK511 and MCBK511, the row pre-decoding signal Qi makes the output of NAND gate 38 become high and repair block selection signal F16B holds the output of NAND gate 40 at high level, thereby causing block word line BWL511 to be pulled up to Vcc so as to activate MCBK511 as a repair block for the defective block MCBK0. Thereafter, a normal read operation begins to read out data from the substituted block MCBK511. The normal reading operation for MCBK511 is well known in this field.

Additionally when a further defective row block such as MCBK3 are found by the aforementioned manner as a eighteenth defective block, the repair block to be substituted for the MCBK3 will be MCBK510. In preparing the flag cell blocks for the automatic mapping configuration, the number of combination codes involved in the substitution capacity may not be limited to that of the described embodiment.

As described before, the nonvolatile memory embodying this invention is able to perform an automatic bad block mapping without effort by an user so that pseudo-useable blocks are arranged on the main memory cell array in a sequential order as if those blocks substantially containing one or more defective blocks are non-defective blocks. Furthermore, since nonvolatile cells are employed in the flag cell blocks as status identification units and interconnection structures are provided for enhancing sensing speed, current consumption thereof may be more reduced as compared with than in the conventional fuse programming redundancy and it is possible to be useful for a high density memory in need of a faster read operation.

Although one embodiment of the invention has been disclosed and described, it will be appreciated that other embodiments and modification of the invention are possible, such as a mapping configuration with column substitutions.

## Claims

1. A semiconductor memory comprising:
a memory cell array (10) consisting of a plurality of normal cell blocks (MCBKi) and a plurality of redundant memory cell blocks (RCBKi);
a plurality of flag cell blocks (FCBKi) arranged in correspondence with said normal cell blocks, each storing unique information about its corresponding normal cell block; and
means for substituting repair blocks for defective blocks of said plurality of normal cell blocks (MCBKi), said repair blocks including said plurality of redundant memory cell blocks (RCBKi) and one or more blocks of said plurality of normal cell blocks (MCBKi), said one or more blocks of said plurality of normal cell blocks (MCBKi) participating in said substitution operation in a sequential order when the number of said defective blocks is greater than that of said redundant memory cell blocks (RCBKi) so as to generate continuous addresses for those normal memory cell blocks that are not used as repair blocks,
whereby said substituting means effects said substitution operation for a defective block on the basis of the unique information stored in the flag cell block (FCBKᵢ) corresponding to said defective block.

2. A semiconductor memory as defined in claim 1, wherein said sequential order is in the order from the most significant bit numbered normal memory block to the least significant bit numbered normal memory block.

3. A semiconductor memory as defined in claim 1 or 2, wherein each of said flag cell blocks (FCBKi) comprises:
a plurality of flag cell strings (52) having a plurality of flag cell transistors (FMCi) connected between a pair of flag string selection transistors (FSTi, 2) arranged serially;
a plurality of flag word lines (FWLi), each being wired to a plurality of word lines which are coupled to control gates of said flag cell transistors (FMCi), and
a plurality of flag bit lines (FBLi), each being connected to a plurality of said flag string selection transistors (FSTi,2).

4. A semiconductor memory as defined in claim 1, 2 or 3, wherein said substituting means comprises:
a sense amplifier (24) for detecting unique information from said flag cell block (FCBKᵢ) so as to generate a defective block status signal;
a flag decoder (26) for generating a repair block selection signal in response to a plurality of said defective block status signals; and
a block selection controller (28) for generating a normal row decoder disable signal in response to said repair block selection signal.

## Patentansprüche

1. Halbleiterspeicher mit
- einem Speicherzellenfeld (10) aus einer Mehrzahl normaler Zellenblöcke (MCBKi) und einer Mehrzahl redundanter Speicherzellenblöcke (RCBKi),
- einer Mehrzahl von Markierzellenblöcken (FCBKi), die korrespondierend zu den normalen Zellenblöcken angeordnet sind und von denen jeder eine spezifische Information über seinen zugehörigen normalen Zellenblock speichert, und
- Mittel zum Ersetzen von defekten Blöcken der Mehrzahl normaler Zellenblöcke (MCBKi) durch Reparaturblöcke, welche die mehreren redundanten Speicherzellenblöcke (RCBKi) und einen oder mehrere der Mehrzahl von normalen Zellenblöcken (MCBKi) umfassen, wobei der eine oder die mehreren Blöcke der Mehrzahl normaler Zellenblöcke (MCBKi) am Ersetzungsvorgang in sequenzieller Reihenfolge teilnehmen, wenn die Anzahl defekter Blöcke größer als diejenige redundanter Speicherzellenblöcke (RCBKi) ist, um kontinuierliche Adressen für diejenigen normalen Speicherzellenblöcke zu erzeugen, die nicht als Reparaturblöcke benutzt werden, wobei die Ersetzungsmittel den Ersetzungsvorgang für einen defekten Block auf der Basis der spezifischen Information bewirken, die in dem zum defekten Block gehörigen Markierzellenblock (FCBKi) gespeichert ist.

2. Halbleiterspeicher nach Anspruch 1, wobei die sequenzielle Reihenfolge eine Reihenfolge ist, die von dem mit dem höchstwertigen Bit bezeichneten normalen Speicherblock bis zu dem mit dem niedrigstwertigen Bit bezeichneten normalen Speicherblock läuft.

3. Halbleiterspeicher nach Anspruch 1 oder 2, wobei jeder der Markierzellenblöcke (FCBKi) folgendes enthält:
- eine Mehrzahl von Markierzellenketten (52) mit einer Mehrzahl von Markierzellentransistoren (FMCi), die zwischen ein Paar seriell angeordneter Markierkettenauswahltransistoren (FSTi, 2) eingeschleift sind,
- eine Mehrzahl von Markierwortleitungen (FWLi), von denen jede mit einer Mehrzahl von Wortleitungen verdrahtet ist, die an Steuergates der Markierzellentransistoren (FMCi) gekoppelt sind, und
- eine Mehrzahl von Markierbitleitungen (FBLi), die jeweils mit einer Mehrzahl der Markierkettenauswahltransistoren (FSTi, 2) verbunden sind.

4. Halbleiterspeicher nach Anspruch 1, 2 oder 3, wobei die Ersetzungsmittel folgendes enthalten:
- einen Abtastverstärker (24) zum Detektieren spezifischer Information aus dem Markierzellenblock (FCBKi), um ein Statussignal bezüglich eines defekten Blocks zu erzeugen,
- einen Markierdecoder (26) zur Erzeugung eines Reparaturblockauswahlsignals in Reaktion auf eine Mehrzahl der Statussignale bezüglich defekter Blöcke und
- eine Blockauswahl-Steuereinheit (28) zur Erzeugung eines Deaktivierungssignals für einen normalen Zeilendecoder in Reaktion auf das Reparaturblockauswahlsignal.

## Revendications

1. Mémoire à semiconduteur comprenant :
un groupement (10) de cellules de mémoire constitué de plusieurs blocs de cellules normales (MCBKi) et d'une pluralité de blocs de cellules de mémoire redondantes (RCBKi) ;
une pluralité de cellules de drapeau (FCBKi) disposées en correspondance avec lesdits blocs de cellules normales, stockant chacun une information unique à propos de son bloc de cellules normales correspondant ; et
un moyen servant à substituer des blocs de réparation à des blocs défectueux d'une pluralité desdits blocs de cellules normales (MCBKi), lesdits blocs de réparation comportant ladite pluralité de blocs de cellules de mémoire redondantes (RCBKi) et un ou plusieurs blocs de ladite pluralité de blocs de cellules normales (MCBKi), ledit ou lesdits blocs de ladite pluralité de blocs de cellules normales (MCBKi) participant à ladite opération de substitution dans un ordre séquentiel lorsque le nombre desdits blocs défectueux est supérieur à celui desdits blocs de cellules de mémoire redondantes (RCBKi) de façon que soient produites des adresses continues pour les blocs de cellules de mémoire normales qui ne sont pas utilisés comme blocs de réparation, si bien que ledit moyen de substitution effectue ladite opération de substitution d'un bloc défectueux sur la base de l'information unique stockée dans le bloc de cellules de drapeau (FCBKi) correspondant audit bloc défectueux.

2. Mémoire à semiconducteur selon la revendication 1, où ledit ordre séquentiel est l'ordre qui va du bloc de mémoire normale numéroté selon le bit de plus grand poids au bloc de mémoire normale numéroté selon le bit de moindre poids.

3. Mémoire à semiconducteur selon la revendication 1 ou 2, où chacun desdits blocs de cellules de drapeau (FCBKi) comprend :
une pluralité de chaînes de cellules de drapeau (52) possédant une pluralité de transistors de cellules de drapeau (FMCi) connectés entre deux transistors de sélection de chaîne de drapeau (FSTi, 2) disposés en série ;
une pluralité de lignes de mot de drapeau (FWLi), qui sont chacune câblées à une pluralité de lignes de mot qui sont couplées à des grilles de commande desdits transistors de cellules de drapeau (FMCi), et
une pluralité de lignes de bit de drapeau (FBLI) qui sont chacune connectées à une pluralité desdits transistors de sélection de chaîne de drapeau (FSTi, 2).

4. Mémoire à semiconducteur selon la revendication 1, 2 ou 3, où ledit moyen de substitution comprend :
un amplificateur de lecture (24) servant à détecter l'information unique venant dudit bloc de cellules de drapeau (FCBKi) afin de produire un signal d'état de bloc défectueux ;
un décodeur de drapeau (26) servant à produire un signal de sélection de bloc de réparation en réponse à une pluralité desdits signaux d'état de bloc défectueux ; et
un dispositif (28) de commande de sélection de bloc servant à produire un signal d'invalidation de décodeur de rangée normal en réponse audit signal de sélection de bloc de réparation.
